# EUROPEAN PATENT APPLICATION

(11) **EP 2 144 310 A1**
(43) Date of publication of application: **13.01.2010**
(21) Application number: 08160087.6
(22) Date of filing: 10.07.2008
(51) Int. Cl.: H01L 51/50, H01L 51/52

(54) **Light emitting device**

(71) Applicant: Koninklijke Philips Electronics N.V., 5621 BA Eindhoven (NL); Philips Intellectual Property & Standards GmbH, 20099 Hamburg (DE)
(72) Inventor: The designation of the inventor has not yet been filed
(74) Representative: Damen, Daniel Martijn

(57) **Abstract**

The invention relates to a light-emitting device comprising at least one light-emitting diode stack (1), said light-emitting diode stack (1) comprising at least
- an anode layer (2)
- a cathode layer (3)
- a light emission layer (4)
- a charge transport layer (5,6) arranged between said light emission layer (4) and at least one of said anode layer (2) and cathode layer (3),
wherein a first domain (21) of said light-emitting diode stack (1) is adapted to provide a first charge injection and/or transport energy barrier, and a second domain (22) of said light-emitting diode stack (1) is adapted to provide a second charge injection and/or transport energy barrier, said first domain (21) being located laterally adjacent to said second domain (22), and said second charge injection and/or transport energy barrier being different from said first charge injection and/or transport energy barrier. The light-emitting device of the invention enables the emission of light of different intensities from the same LED.

## Description

### FIELD OF THE INVENTION

The present invention relates to the field of LED-based light-emitting devices comprising at least one LED stack, said LED stack comprising at least an anode layer, a cathode layer, a light emission layer, and a charge transport layer arranged between said light emission layer and at least one of said anode layer and said cathode layer.

### BACKGROUND OF THE INVENTION

Light emitting diode (LED) based light-emitting devices are today increasingly used for a wide variety of lighting applications. In particular, organic light-emitting devices (OLEDs) are increasingly used for signage lighting, such as advertising information and indication signs.

OLED signage may be produced on different substrates such as rigid substrates (e.g. metal, glass) or flexible substrates (e.g. PEN, PET) and displaying either static images (in the case of single pixel patterned OLED) or dynamic images (in the case of active matrix display). The patterning of OLEDs can be achieved by a variety of methods such as patterning of the organic stack (e.g. screen-printing, ink-jet printing) or patterning of the electrode (e.g. evaporation through a shadow mask). However, a drawback of conventional patterned OLED signage is that only the signage and not the background emits light, and therefore additional illumination is often required in order for the signage to be clearly visible. In particular this is true for signage placed in a dark environment. The use of additional light sources requires a more complex infrastructure and more energy.

US 2001/0001485 (Bao et al) discloses an OLED device that emits light in a pattern. The patterned emission is defined by a patterned layer in the active material of the LED device. The patterned layer has at least a first thickness and a second thickness. When the device is on, the portion of the device associated with the first thickness of the patterned layer is visually distinct from the portion of the device that is associated with the second thickness of the patterned layer. However, one disadvantage of this device is that it might be very unstable electrically, because a thickness variation of a layer implies an electrical field variation in that layer, resulting in weak spots in the device.

### SUMMARY OF THE INVENTION

It is an object of the invention to at least partly overcome the above-mentioned drawbacks of the prior art.

In one aspect of the invention, there is provided a light emitting device comprising at least one light-emitting diode stack, said light-emitting diode stack comprising at least
- an anode layer
- a cathode layer
- a light emission layer
- a charge transport layer arranged between said light emission layer and at least one of said anode layer and said cathode layer,
wherein a first domain of said light-emitting diode stack is adapted to provide a first charge injection and/or transport energy barrier, and a second domain of said light-emitting diode stack is adapted to provide a second charge injection and/or transport energy barrier, said first domain being located laterally adjacent to said second domain, and said second charge injection and/or transport energy barrier being different from said first charge injection and/or transport energy barrier.

The light-emitting device of the invention enables the emission of light of different intensities from the same LED. For example, a bright signage on a weakly lit background may be generated. The light-emitting device of the invention thus evades the need of an additional light source for illuminating the signage.

The invention allows the use of multiple domains having different charge injection barriers, so that when a small voltage is applied, only those regions of the LED associated with the lowest charge injection barrier will emit light. At the application of a higher voltage, another region having a higher charge injection and/or transport energy barrier will also emit light. Consequently, by suitably chosing the applied voltage, one region of an LED of a light emitting device according to embodiments of the invention may be caused to emit light while another region does not emit light, or the regions may both emit light but of different intensities. The invention thus allows the production of OLED signages in which the signage (e.g. text or images) may be changed by varying the applied voltage over time.

By adapting the layers of the LED stack, no additional production steps outside the LED stack production line are required. For example, structuring of an insulation layer by photolithography may be avoided. Furthermore, adapting a charge injection and/or transport energy barrier enables large differences in intensity between different regions of the LED stack without substantially affecting the thickness of the LED. Also, high contrast may be achieved using low voltage.

In embodiments of the invention, the light emission layer is an organic light emission layer. The use of OLEDs in the present invention is particularly advantageous since OLEDs may be used as large area light sources.

It may be preferred to selectively adapt the energy barrier of the injection of holes from the anode layer. Therefore, in embodiments of the invention, said first domain and said second domain may be located between the light emission layer and the anode layer. Alternatively, in some instances it may be preferred to selectively adapt the energy barrier of the injection of electrons from the cathode; in such embodiments, said first domain and said second domain are located between the light emission layer and the cathode layer.

Furthermore, in embodiments of the invention the LED stack further comprises at least one charge injection promoting layer. By including a hole or electron injection promoting layer the energy barrier of injection of holes or electrons, respectively, is decreased, resulting in a higher light output using the same applied voltage. By including an integral charge injection promoting layer, the efficiency of the light-emitting device may be improved. Alternatively, by including a partial charge injection promoting layer, which is present in some domains only, high contrast between different regions of the LED may be achieved using a low applied voltage.

In embodiments of the invention, said second charge injection and/or transport energy barrier may be obtained in said second domain of the LED stack by omission of a layer present in said first domain of the LED stack, and/or by addition of layer not present in said first domain of the LED stack. Herein, this is also referred to as using a partial layer. Advantageously, a partial layer may be designed to be invisible when the device is in the off state. Moreover, both a region comprising said layer and a region not comprising said layer may emit light.

Thus, for example, said first domain may comprise a charge injection promoting layer that is not present in said second domain. Alternatively, said second domain may comprise a charge injection obstructing layer that is not present in said first domain.

In embodiments of the invention, said first and/or second charge injection and/or transport energy barrier(s) may be obtained in said first and/or second domain(s) of said light-emitting diode stack by modification of at least one of said anode layer and said cathode layer to alter the work function thereof. For example, said first domain may comprise a surface modification of the anode layer. Alternatively or additionally, said second domain may comprise a surface modification of the anode layer.

In embodiments of the invention, said first domain of the LED stack comprises an amount of a doping material different from an amount of said doping material in said second domain of the LED stack.

In another aspect, the invention relates to a method for producing a light-emitting device as described above, comprising adapting a first charge injection and/or transport energy barrier in a first domain of said light-emitting diode stack by any one of the following: omitting a charge injection promoting layer in said first domain, said charge injection promoting layer being present in said second domain; adding a charge injection obstructing layer in said first domain, said charge injection obstructing layer being absent in said second domain; surface modifying at least one of said anode layer and said cathode layer; including an amount of doping material different from the amount of said doping material in said second domain; and any combination thereof. Advantageously, by adapting the layers of the LED stack, no additional signage production steps outside the LED stack production line are required.

### BRIEF DESCRIPTION OF THE DRAWINGS

Fig. 1 is a schematic cross-sectional illustration of a conventional OLED stack.
Fig. 2 is a schematic cross-sectional illustration of an OLED of a light-emitting device according to an embodiment of the invention.
Fig. 3 is a schematic cross-sectional illustration of an OLED of a light-emitting device according to another embodiment of the invention.
Fig. 4 is a schematic representation of the energy levels associated with an OLED of a light-emitting device according to an embodiment the invention.

### DETAILED DESCRIPTION OF THE INVENTION

As used herein, a charge transport layer refers to a layer through which charges (electron or holes) are transported. A charge injection layer may be regarded as a type of charge transport layer. For example, in simple OLED stacks, a single charge injection layer, preferably a hole injection layer, may serve as the only charge transport layer.

The invention will now be described with reference to the appended drawings.

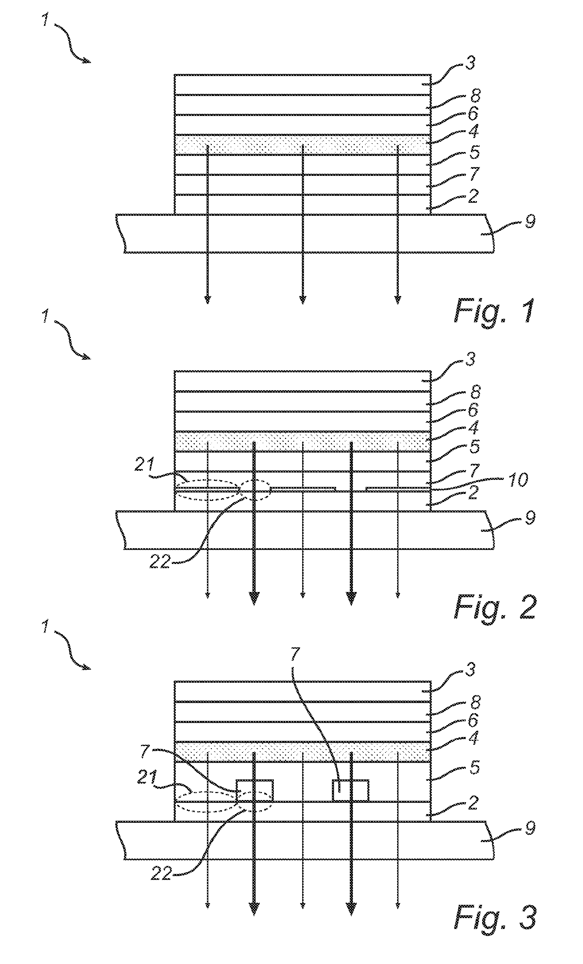

Fig. 1 shows a conventional layer stack 1 of an OLED of a bottom emissive configuration. The OLED stack 1 comprises an anode layer 2 and a cathode layer 3. Between the anode layer 2 and the cathode layer 3 are sandwiched a light emission layer 4, a hole transport layer 5 and an electron transport layer 6. In the hole and electron transport layers 5 and 6 (collectively referred to as "charge transport layers"), holes and electrons respectively are transported to the organic light emission layer 4, where the holes and electrons combine, which results in the emission of light (represented by arrows). A hole injection layer 7 is provided between the anode layer 2 and the hole transport layer 5 to improve injection of holes from the anode layer 2 into the hole transport layer 5. Also, an electron injection layer 8 is provided between the cathode layer 3 and the electron transport layer 6 to improve the injection of electrons from the cathode layer 3 into the electron transport layer 6. The stack 1 is arranged on a light transmissive substrate 9.

Fig. 2 shows a LED stack of a light-emitting device according to an embodiment of the invention. The stack 1 comprises an anode layer 2 and a cathode layer 3. The anode layer 2 may be of any conventional anode layer material, such as metal (e.g. platinum, gold, palladium, indium); metal oxide (e.g. tin oxide, ITO (Indium Tin Oxide), doped zinc oxide, or doped conducting polymers (polyaniline, polypyrrole, polythiophene). The cathode layer 3 may comprise any conventional cathode material, such as barium, lithium fluoride and/or aluminium. Other suitable electrode materials are known to those skilled in the art. In the embodiment shown in Fig. 2, the anode layer 2 is light transmissive, thus allowing light to exit the stack 1 through the anode layer 2. Alternatively, the cathode layer 3 may be light transmissive, or both the anode layer 2 and the cathode layer 3 may be light transmissive.

Between the anode layer 2 and the cathode layer 3 is provided a light emission layer 4. In the light emission layer 4, holes originating from the anode layer 2 and electrons originating from the cathode layer 3 combine, which results in the emission of light (represented by arrows). The light emission layer 4 is typically an organic light emission layer. For example, the light emission layer 4 may comprise an organo-metallic chelate such as Tris(8-hydroxyquinolinato)aluminium (Alq3), or a conducting polymer. Suitable materials for an organic light emission layer are known to those skilled in the art.

Between the anode layer 2 and the light emission layer 4 are provided a hole injection promoting layer 7 and a hole transport layer 5. The hole injection promoting layer 7, hereinafter referred to as the hole injection layer 7, is a layer provided to improve the injection of holes from the anode layer 2 into the hole transport layer 5 by decreasing the energy barrier for hole injection. Examples of suitable materials for the hole injection layer include 4,4',4''-Tris(N-(1-naphthyl)-N-phenyl-amino)-triphenylamine (MTDATA), polyethylene dioxythiophene (PEDOT), and metal phthalocyanine. Examples of suitable materials for the hole transport layer include polythiophene, derivatized polythiophene, oligomeric polythiophene, derivatized oligomeric polythiophene, pentacene, diamine (e.g. N,N'-di-1-naphthyl-N,N'-diphenyl-1,1'-biphenyl-4,4'diamine (NPD)), and alpha-NPD (N,N'-Di(naphthalen-1-yl)-N,N'-diphenyl-benzidine).

Similarly, an electron injection promoting layer 6, hereinafter referred to as electron injection layer 6, and an electron transport layer 8 are provided between the cathode layer 3 and the light emission layer 5. The electron injection layer 8 is arranged between the cathode layer 3 and the electron transport layer 6. The electron injection layer 8 is serves improve the injection of electrons from the cathode layer 3 into the electron transport layer 6 by decreasing the energy barrier for electron injection. Examples of suitable materials for an electron injection or transport layer include Tris-(8-hydroxy-chinolinato)-Al (Alq3), 3-(4-biphenylyl)-4-phenyl-5-tertbutylphenyl-1,2,4-triazole (TAZ), 1,3,5-tris-(1-phenyl-1H-benzimidazol-2-yl)-benzene (TPBI). Also, BaO could be considered for an electron injection layer.

The presence of a charge (i.e., hole and/or electron) injection promoting layer achieves a decrease of the energy barrier of charge injection from the respective electrode into the respective charge transport layer. The thickness of any charge injection layer may depend on the material and the deposition conditions used, but is generally in the nanometer-scale range. However, thickness variations of the charge injection layer will not affect the energy barrier decrease. Thus, where a charge injection layer is present, irrespective of its thickness, there will be a certain decrease of the charge injection energy barrier, and as a result, light emission will occur at a lower applied voltage.

In the embodiment of the invention represented in Fig. 2, a domain 21 of the LED stack 1 comprises a surface modification 10 of the anode layer 2, which modification is provided to locally match or mismatch the work function of the anode layer 2 with the energy level of the hole injection layer 7, i.e., to decrease or increase the energy barrier for hole injection. The surface modification may be obtained e.g. by oxygen or CF4 plasma treatment, UV ozone treatment, or self-assembly monolayers (SAM) to locally increase or decrease the work function of the anode layer. Suitable surface modification methods are known to those skilled in the art.

At the domain 21 where the energy barrier for injecting holes into the hole injection layer 7 is increased, fewer holes will be injected into the hole injection and hole transport layers 7 and 5, and thus, locally, fewer holes will reach the light emission layer 4. As a result of fewer recombination events therein, less light emitted from a region of the light emission layer 4 associated with a region of the anode layer 2 which has an increased work function (i.e. a domain 21 having an increased hole injection energy barrier). In contrast, a region of the anode layer 2 which is not modified to increase the work function thereof does not have an increased hole injection energy barrier, and therefore the number of holes injected from this region will not be reduced. As a result, light of higher intensity is emitted from a region of the light emission layer 4 associated with a region of the anode layer 2 which has a normal work function compared to the intensity of light emitted from a region of the light emission layer 4 associated with a region of the anode layer 2 which has an increased the work function. Thus, an LED emitting light of different intensities is obtained. Typically, an LED of a light-emitting device according to embodiments of the invention produces light of at least two different intensities. Such an LED, in particular an OLED, may be advantageously used in light-emitting devices e.g. for signage or decorative lighting applications.

The invention thus allows the use of multiple domains having different charge injection barriers, so that when a small voltage is applied, only those regions of the LED associated with the lowest charge injection barrier will emit light. At the application of a higher voltage, another region having a higher charge injection and/or transport energy barrier will also emit light. Consequently, by suitably chosing the applied voltage, one region of the LED of a light emitting device according to embodiments of the invention may be caused to emit light while another region does not emit light, or the regions may both emit light but of different intensities. Moreover, by using multiple domains having different charge injection and/or transport energy barriers and by suitably chosing the applied voltage, one region of the LED of a light-emitting device according to embodiments of the invention may be caused to emit light of a different intensity than that emitted by another region, while yet another region of the LED still does not emit light. The invention thus allows the production of OLED signages in which the signage (e.g. text or images) may be changed by varying the applied voltage over time (but keeping the applied voltage the same for all domains of the LED at any time).

The hole transport layer 5 and the hole injection layer 7 may be light transmissive. Also, the electron transport layer 6 and the electron injection layer 8 may be light transmissive. In embodiments in which the anode layer 2 is light transmissive, the hole transport layer 5 and the hole injection layer 7 are preferably also light transmissive, so that light emitted by the light emission layer 4 may exit the LED stack 1 via the anode layer 2 (so-called bottom emissive configuration). Similarly, in embodiments in which the cathode layer 3 is light transmissive, the electron transport layer 6 and the electron injection layer 8 are preferably also light transmissive, so that light emitted by the light emission layer 4 may exit the LED stack 1 via the cathode layer 3 (so-called top emissive configuration). Alternatively, both the anode layer 2 and the cathode layer 3 and all layers arranged therebetween may be at least partly light transmissive so as to provide a translucent LED stack.

In the embodiment represented in Fig. 3, a light emission layer 4 is provided between an anode layer 2 and a cathode layer 3. A hole transport layer 5 is provided between the anode layer 2 and the light emission layer 4, and an electron transport layer 6 is provided between the cathode layer 3 and the light emission layer 4. Also, an electron injection layer 8 is provided between the cathode layer 3 and the electron transport layer 6. The anode layer 2, the cathode layer 3, the charge transport layers 5 and 6, and the electron injection layer 8 may be as described above.

Furthermore, a domain 22 of the LED stack 1 between the anode layer 2 and the light emission layer 4 comprises a hole injection layer 7. Preferably, the hole injection layer 7 is provided between the anode layer 2 and the hole transport layer 5. The presence of the hole injection layer 7 locally decreases the hole injection energy barrier so that, from regions of the anode layer 2 adjacent a domain 22 comprising a hole injection layer 7, holes will be more easily injected into the hole transport layer 5. As a result, more light is emitted from a region of the light emission layer 4 associated with a domain 22 of the LED stack 1 comprising a hole injection layer 7 than from a region of the light emission layer 4 associated with a domain 21 which does not comprise a hole injection layer 7. Thus, by including a partial hole injection promoting layer, an LED emitting light of different intensities may obtained.

Instead of, or in addition to, a partial hole injection layer 7, a partial electron injection layer may be provided between the cathode layer 3 and the light emitting layer 4. For example, a partial electron injection layer may be provided between the cathode layer 3 and the electron transport layer 6. The presence of an electron injection layer will decrease the electron injection energy barrier so that, from a region of the cathode layer 3 adjacent a domain comprising an electron injection layer, electrons will be more easily injected into the electron transport layer 6.

The partial hole or electron injection layer may be obtained by known techniques, for example by patterning with shadow mask evaporation, printing techniques (inkjet, slot-die, etc).

In embodiments of the invention, a partial charge injection obstructing layer may be provided between the anode layer 2 and the light emission layer 4, or between the cathode layer 3 and the light emission layer 4. For example, the OLED stack 1 of Fig 1 may be adapted according to embodiments of the invention so that a first domain of the stack 1 comprises a hole injection obstructing layer arranged between the hole injection layer 7 and the hole transport layer 5, or between the anode layer 2 and the hole injection layer 7. The presence of a hole injection obstucting layer will increase the energy barrier for hole injection into the hole transport layer 5, which will result in a locally reduced light intensity as described above. In contrast, a domain of the LED stack 1 which does not comprise such a hole injection obstructing layer will result in light of unreduced intensity. Suitable materials for a hole or electron injection obstructing layer are known to those skilled in the art.

In embodiments of the invention, the difference in charge injection and/or transport energy barriers may be achieved by the use of a doping material in a charge transport layer. For example, in a first domain of the LED stack, the hole transport layer may contain an amount of doping material which increases the hole transport energy barrier of said first domain compared to that of a second domain not containing said doping material or containing a lesser amount of said doping material. The amount of said doping material in each domain may be in the range of from 0 to 30 % by weight. Typically, a doping material suitable for increasing the hole transport energy barrier is a poor hole conductor and/or a good electron conductor. As another example, in a first domain of the LED stack the electron transport layer may contain an amount of doping material which increases the electron transport energy barrier of said first domain compared to that of a second domain not containing said doping material or containing a lesser amount of said doping material. The amount of said doping material in each domain may be in the range of from 0 to 30 % by weight. Typically, a material suitable for increasing the electron transport energy barrier is a poor electron conductor and/or a good hole conductor.

The doping material provides a conducting path via its HOMO (highest occupied molecular orbital) or LUMO (lowest unoccupied molecular orbital) levels for the transport of the respective charges. Suitable doping materials are known to a person skilled in the art.

Furthermore, in embodiments of the invention, the light-emitting device may comprise a third domain of the LED stack which domain is adapted to provide a third charge injection and/or transport energy barrier, said third domain being located laterally adjacent to said first domain and/or said second domain. Typically, said third charge injection and/or transport energy barrier is different from said first charge injection and/or transport energy barrier and said second injection and/or transport energy barrier. The light emitting device may also comprise even further domains, each domain being adapted to provide a different charge injection and/or transport energy barrier. A light emitting device comprising an LED, in particular an OLED, having different regions each corresponding to a domain of a different charge injection and/or transport energy barrier may be very useful for the production of complex signages.

The LED stack of the invention is not limited to the layouts presented above, but may be applied any other known LED layouts, for example in a cathode-down LED device.

The invention will now be further described by way of example.

### Examples

### Example 1

A simple OLED stack was produced comprising the following layers in this order: glass substrate/ITO anode/NPD (N,N'-di-1-naphthyl-N,N'-diphenyl-1,1'-biphenyl-4,4'diamine) hole injection layer/Alq3 emission layer/ LiF-Al cathode.

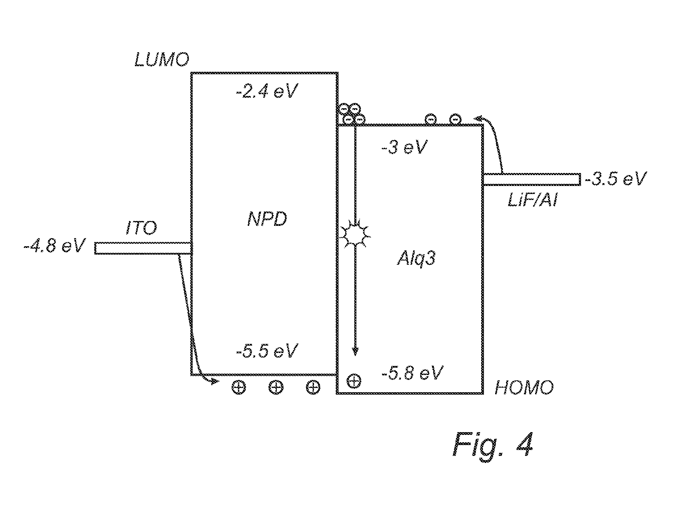

The NPD was a partial layer, being present only in some domains of the LED stack. It was applied by patterning with a shadow mask using conventional methods. In domains of the stack in which the NPD layer was present, the hole injection energy barrier decreased with 0.2-0.3 eV compared to domains in which there was no NPD layer. The energy levels of this device are illustrated in Fig. 4.

Advantageously, when the OLED device is in the off state, the partial NPD layer is not visible.

### Example 2

A green OLED stack was produced comprising the following layers: glass substrate/ITO anode/hole injection layer/hole transport layer/emission layer/electron transport layer/electron injection obstructing layer (NPD)/electron injection layer/LiF-AL cathode.

Suitable materials for the charge injection and charge transport layers of this example are known to those skilled in the art. For example, the following materials may be used:
- hole injection layer: MTDATA
- hole transport layer: alpha-NPD
- emission layer: TCTA doped with Ir(ppy)3
- electron transport layer: TPBI
- electron injection layer: Alq3

The partial electron injection obstructing layer was an extra NPD layer produced by masked evaporation. As a result, light of lower intensity was emitted from regions of the light emission layer associated with domains of the LED stack comprising the extra NPD layer. Thus a very high contrast between different regions of the OLED device could be achieved. Also, since the light intensity depends on the applied voltage, by varying the applied voltage (but keeping the voltage over both regions the same at each time), the light output ratio of the OLED regions could be varied.

The light output of two different regions (A and B) of this OLED device was measued using a conventional method. Region B comprises an extra NPD layer, whereas region A does not. The results are presented in Table 1.

**Table 1**

| Applied voltage (V) | Current (A) | | Light output (cd/m²) | |
|---|---|---|---|---|
| | region A | region B | region A | region B |
| 2,2 | 1.5 x 10⁻⁶ | 9 x 10⁻⁸ | 3 | 0.15 |
| 2.4 | 1.4 x 10⁻⁵ | 3 x 10⁻⁷ | 35 | 0.59 |
| 2.6 | 7 x 10⁻⁵ | 8 x 10⁻⁷ | 184 | 1.53 |
| 3.0 | 7.5 x 10⁻⁴ | 3 x 10⁻⁶ | 1687 | 0.15 |

It shall be noted that the embodiments of the invention described above are exemplary and not limitative of the scope of the invention.

## Claims

1. Light-emitting device comprising at least one light-emitting diode stack (1), said light-emitting diode stack (1) comprising at least
- an anode layer (2)
- a cathode layer (3)
- a light emission layer (4)
- a charge transport layer (5,6) arranged between said light emission layer (4) and at least one of said anode layer (2) and cathode layer (3),
wherein a first domain (21) of said light-emitting diode stack (1) is adapted to provide a first charge injection and/or transport energy barrier, and a second domain (22) of said light-emitting diode stack (1) is adapted to provide a second charge injection and/or transport energy barrier, said first domain (21) being located laterally adjacent to said second domain (22), and said second charge injection and/or transport energy barrier being different from said first charge injection and/or transport energy barrier.

2. Light-emitting device according to claim 1, wherein said light emission layer (4) is an organic light emission layer.

3. Light-emitting device according to claim 1 or 2, wherein said first domain (21) and said second domain (22) are located between said light emission layer (4) and said anode layer (2).

4. Light-emitting device according to claim 1 or 2, wherein said first domain and said second domain are located between said light emission layer (4) and said cathode layer (3).

5. Light-emitting device according to any one of the preceding claims, wherein said light-emitting diode stack (1) further comprises at least one charge injection promoting layer (7, 8).

6. Light-emitting device according to any one of the preceding claims, wherein said second charge injection and/or transport energy barrier is obtained in said second domain (22) of said light-emitting diode stack (1) by addition of layer not present in said first domain (21) of said light-emitting diode stack (1), and/or by omission of a layer present in said first domain (21) of said light-emitting diode stack (1).

7. Light-emitting device according to claim 6, wherein said second domain (22) comprises a charge injection promoting layer (7) that is not present in said first domain (21).

8. Light-emitting device according to claim 6, wherein said second domain (22) comprises a charge injection obstructing layer that is not present in said first domain (21).

9. Light-emitting device according to any one of the claims 1 to 5, wherein said first and/or second charge injection and/or transport energy barrier(s) is/are obtained in said first and/or second domain(s) of said light-emitting diode stack (1) by modification of at least one of said anode layer (2) and said cathode layer (3) to alter the work function thereof.

10. Light-emitting device according to claim 9, wherein said first and/or second domain comprise(s) a surface modification of the anode layer (2).

11. Light-emitting device according to any one of the claims 1 to 5, wherein said first domain (21) comprises an amount of a doping material different from an amount of said doping material in said second domain (22).

12. Method for producing a light-emitting device according to any one of the claims 1 to 5, comprising adapting a first charge injection and/or transport energy barrier in a first domain (21) of said light-emitting diode stack (1) by any one of the following: adding a charge injection obstructing layer in said first domain (21), said charge injection obstructing layer being absent in said second domain (22); omitting a charge injection promoting layer (7, 8) in said first domain (21), said charge injection promoting layer (7,8) being present in said second domain (22); surface modifying at least one of said anode layer (2) and said cathode layer (3); including an amount of doping material different from an amount of said doping material in said second domain; and any combination thereof.
